# EUROPÄISCHE PATENTSCHRIFT

(11) **EP 2 523 044 B1**
(45) Veröffentlichungstag und Bekanntmachung des Hinweises auf die Patenterteilung: **10.02.2016**
(21) Anmeldenummer: 12450019.0
(22) Anmeldetag: 12.04.2012
(51) Int. Cl.: G03F 7/00, G03F 7/20, B41C 1/055, G03B 27/26

(54) **Vorrichtung zum Herstellen von Stempel-Klischees**
Device for producing stamp printing plates
Dispositif de fabrication de clichés pour tampons

(30) Priorität: 13.04.2011 AT 5252011
(43) Veröffentlichungstag der Anmeldung: 14.11.2012
(73) Patentinhaber: COLOP STEMPELERZEUGUNG SKOPEK GESELLSCHAFT M.B.H. & CO. KG., 4600 Wels (AT)
(72) Erfinder: Faber, Ernst, 4600 Wels (AT)
(74) Vertreter: Sonn & Partner Patentanwälte

(56) Entgegenhaltungen:
- EP-B1- 0 810 100
- WO-A1-96/22874
- DE-A1- 3 829 555
- DE-U1- 9 106 621
- FR-A1- 2 004 049
- JP-A- 1 307 758
- US-A- 3 604 798

## Beschreibung

Die Erfindung betrifft eine Vorrichtung zum Herstellen von Stempel-Klischees durch örtliches Belichten und Erhitzen eines Stempelplatten-Rohlings aus einem porösen, thermoplastischen Material, mit wenigstens einer Belichtungslampe, die in einem Gehäuse unter einer Glasplatten-Auflage für den Rohling angeordnet ist, gemäß dem Oberbegriff von Anspruch 1.

Eine derartige Vorrichtung wird in der Praxis auch als "Flash-Maschine" bezeichnet. Bei dieser Technik wird bei einem offenporigen Schaumstoff-Material, wie z.B. EVA (Ethylen-Vinyl-Acetat), zur Herstellung einer Stempelplatte mittels kurzzeitiger Belichtungen ("Flash-Blitz", insbesondere von Xenon-Leuchten) ein Verschließen von Poren des offenporigen Materials des Stempelplatten-Rohlings in jenen Bereichen herbeigeführt, wo kein Stempelabdruck zu erzeugen ist. In jenen Bereichen, in denen ein Stempelabdruck mit Hilfe von durch das poröse Material hindurchtretender Stempelfarbe erzeugt werden soll, bleiben hingegen die Poren offen.

Ein derartiger Flash-Stempel ist beispielsweise in der EP 1 976 705 B1 beschrieben.

Eine Vorrichtung zur Erzeugung einer solchen Flash-Stempelplatte, genauer gesagt eines Klischees auf einem Stempelplatten-Rohling aus einem porösen, thermoplastischen Material, ist beispielsweise aus der EP 805 745 B1 bzw. der dieser entsprechenden WO 96/22874 A bekannt. Bei dieser Technik wird ein Stempelplatten-Rohling in eine Belichtungsvorrichtung gelegt, und zwar zusammen mit einer Schablone oder Maske, die beispielsweise mit Hilfe eines Computers erzeugt wurde, und die das gewünschte Stempelabdruckbild aufweist. Als Auflage-"Tisch" dient in der Belichtungsvorrichtung üblicherweise eine Glasplatte, gegen die die Einheit aus Schablone und Stempelplatten-Rohling mit Hilfe eines Pressteils, mit Hilfe eines Verschlussdeckels, gedrückt wird. Spezielle Stempelplattenmaterialien für dieses Flash-Verfahren sind beispielsweise auch aus der EP 810 100 B1 bekannt.

In der Praxis hat sich bei der Verwendung der vorgenannten Flash-Vorrichtungen gezeigt, dass bei Belichtung einer größeren Anzahl von Stempelplatten-Rohlingen, also bei Herstellung einer entsprechenden Anzahl von fertigen Stempelplatten nach dem Flash-Verfahren, rasch eine Überhitzung in dem Bereich, wo die Stempelplatten-Rohlinge eingelegt werden, also insbesondere der Glasplatten-Auflage, eintritt. Eine derartige Überhitzung kann, wenn sie nicht bemerkt wird, dazu führen, dass in Bereichen der Stempelplatte, wo die Poren offen bleiben sollen, bereits ein ungewolltes Verschließen von Poren nur aufgrund des Einlegens und Zusammenpressens, d.h. Schließen des Deckels, bewirkt wird, nämlich durch die heiße Glas-Auflage, wobei überdies ein derartiges teilweises Verschließen der Poren möglicherweise nicht bemerkt wird, so dass ungeeignete Stempelplatten erzeugt werden. Im günstigeren Fall sind, wenn derartige Überhitzungen festgestellt werden, nachteilige Wartezeiten notwendig, um die Vorrichtung bzw. deren relevante Teile wieder auskühlen zu lassen, was zeitaufwändig ist und die Herstellung einer Serie von Stempelplatten verkompliziert.

Es ist nun Aufgabe der Erfindung, hier Abhilfe zu schaffen und eine Vorrichtung wie eingangs angegeben vorzuschlagen, mit der auch große Serien von Stempelplatten mit Hilfe der beschriebenen Flash-Technologie in kurzen Zeiten hergestellt werden können.

Zur Lösung dieser Aufgabe sieht die Erfindung eine Vorrichtung wie in Anspruch 1 definiert vor. Vorteilhafte Ausführungsformen bzw. Weiterbildungen sind in den abhängigen Ansprüchen angegeben.

Bei der vorliegenden Vorrichtung, die in an sich herkömmlicher Weise eine Belichtungslampe und über dieser eine Glasplatten-Auflage für einen Stempelplatten-Rohling innerhalb eines Gehäuses aufweist, ist somit die Glasplatten-Auflage mit (zumindest) zwei in Abstand voneinander, unter Bildung eines Zwischenraums, angeordneten Glasplatten gebildet; in der Betriebsstellung liegen diese Glasplatten übereinander, und der (Luft-)Zwischenraum zwischen den Glasplatten wirkt als Isolierung, um die von der Belichtungslampe entwickelte Hitze, die zur Erwärmung der unteren Glasplatte führt, von der oberen Glasplatte und damit vom darauf aufgelegten Stempelplatten-Rohling fern zu halten.

Weiters sind bei der vorliegenden Vorrichtung im Gehäuse zwei Kühlluft-Ventilatoren angebracht, wobei im Bereich der Belichtungslampe ein erster Kühlluftpfad gegeben ist. Es wird somit zusätzlich der Bereich der Belichtungslampe durch die vom Ventilator durch diesen Bereich transportierte Kühlluft gekühlt, so dass auch die untere Glasplatte gekühlt wird, was zusätzlich zum vorgenannten Isolier-Zwischenraum eine Überhitzung der oberen Glasplatte sicher vermeiden hilft.

Für eine besonders effiziente Wirkungsweise bildet bei der vorliegenden Vorrichtung auch der Zwischenraum zwischen den Glasplatten einen weiteren Kühlluftpfad. Auf diese Weise wirkt der Zwischenraum zwischen den Glasplatten nicht nur isolierend, er wird auch zusätzlich gekühlt, so dass die obere Glasplatte und damit die darauf aufgelegten Stempelplatten-Rohlinge auf besonders einfache Weise immer im erlaubten Temperaturbereich gehalten werden.

Der Vollständigkeit halber sei noch erwähnt, dass es bei andersartigen Vorrichtungen, nämlich bei früheren Kopiergeräten, Durchlicht-Beleuchtungsgeräten und dergl. Vorrichtungen, s. z.B. DE 91 06 621 U1, FR 2 004 049 A1, US 3,604,798 A, DE 38 29 555 A1 und JP 1-307758 A, bereits bekannt war, Kühleinrichtungen im Bereich von Objekt-Trägern vorzusehen.

Eine besonders effiziente Kühlung mit kleinen Ventilator-Konstruktionen, mit flacher Bauweise, wird dadurch ermöglicht, dass das Gehäuse an zwei einander gegenüberliegenden Seiten mit jeweils einem Ventilator versehen ist, von dem einer als Druck-Gebläse und der andere als Saug-Gebläse vorgesehen ist. Die beiden Ventilatoren an den gegenüberliegenden Seiten des Gehäuses können dabei so flach gebaut sein, dass mit dem Einbau der Ventilatoren praktisch keine Vergrößerung der Breite der Vorrichtung einhergeht. Nichtsdestoweniger kann die summierte Druck- bzw. Saugwirkung zu einem adäquaten Durchsatz von Kühlluft im Bereich der Belichtungslampe und der unteren Glasplatte führen.

Vorzugsweise ist an jedem Ventilator ein Luftfilter vorgesehen, um so den fraglichen Raum im Bereich der Belichtungslampe frei von Partikeln zu halten, was deshalb von Wichtigkeit ist, da derartige Partikel beim "Flashen" auf dem Stempelplatten-Rohling unerwünscht abgebildet werden könnten: Es könnten dort in Bereichen, wo ein Verschließen der Poren gewünscht ist, durch die "Abschattung" zufolge der Partikel Teilbereiche mit offen bleibenden Poren herbeigeführt werden.

Für einen Schutz der Ventilatoren, gegebenenfalls auch der Luftfilter, ist es weiters günstig, wenn jedem Ventilator eine seitlich am Gehäuse angebrachte Abdeckung, die einen Luftkanal definiert, zugeordnet ist.

Eine vorteilhafte Ausführungsform der vorliegenden Vorrichtung zeichnet sich weiters dadurch aus, dass die beiden Glasplatten verschieden dick sind, wobei die dünnere Glasplatte benachbart der Belichtungslampe als Schutz für diese und die dickere Glasplatte als Auflage für den Rohling vorgesehen ist. Dabei kann die dickere Glasplatte beispielsweise ca. 8 mm dick sein, wobei eine ausreichende Festigkeit im Hinblick auf den Anpressdruck beim Anpressen des Stempelplatten-Rohlings und der Schablone erzielt wird. Die dünnere Glasplatte kann, da sie keinen derartigen mechanischen Beanspruchungen unterworfen ist, wesentlich dünner sein, beispielsweise nur ca. 2 mm dick sein.

Der Abstand zwischen den beiden übereinander angeordneten Glasplatten kann beispielsweise ca. 2 mm betragen, wobei einerseits eine ausreichende Isolierwirkung erzielt wird, andererseits eine niedrige Bauweise der Vorrichtung und eine Vereinfachung der Halterungen für die Glasplatten ermöglicht wird.

Die Glasplatten können aus jedem beliebigen transparenten Material, insbesondere aus Acrylglas, bestehen.

Die Erfindung wird nachfolgend anhand von in der Zeichnung veranschaulichten bevorzugten Ausführungsbeispielen, auf die sie jedoch nicht beschränkt sein soll, noch weiter erläutert. Im Einzelnen zeigen in der Zeichnung:
Fig. 1 einen Querschnitt durch eine Vorrichtung zum Herstellen von Stempel-Klischees durch lokales Belichten und Erhitzen eines Stempelplatten-Rohlings, nachstehend kurz "Flash-Vorrichtung" genannt, wobei auch ein Kühlschema in Form von Kühlluftpfaden veranschaulicht ist;
Fig. 2 einen Längsschnitt durch eine derartige Flash-Vorrichtung, mit geöffnetem Deckel;
Fig. 3 ein Detail III gemäß Fig. 1, zur Veranschaulichung des Zwischenraums zwischen den beiden Glasplatten der Glasplatten-Auflage und der Kühlluft-Pfade; und
Fig. 4 das Detail IV aus Fig. 2, zur Veranschaulichung der Auflagerung der oberen, dickeren Glasplatte an einem Rahmen im Gehäuse der Flash-Vorrichtung.

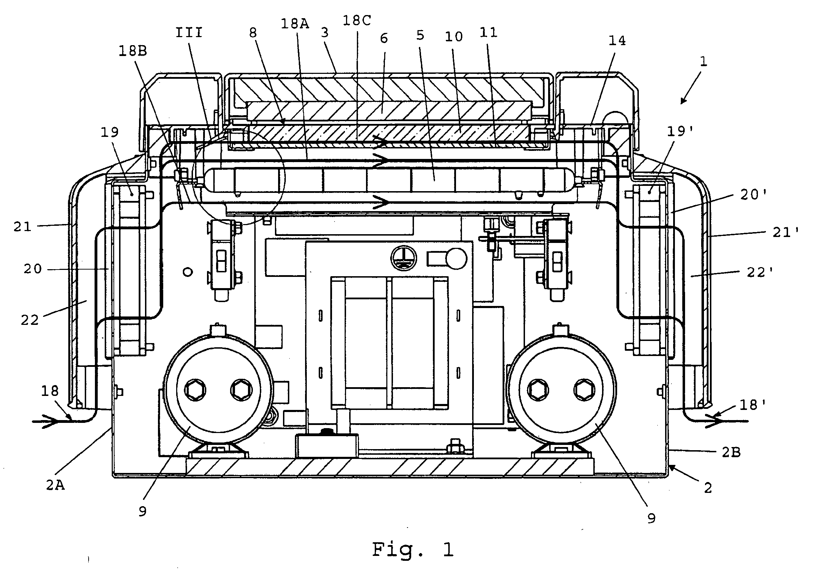

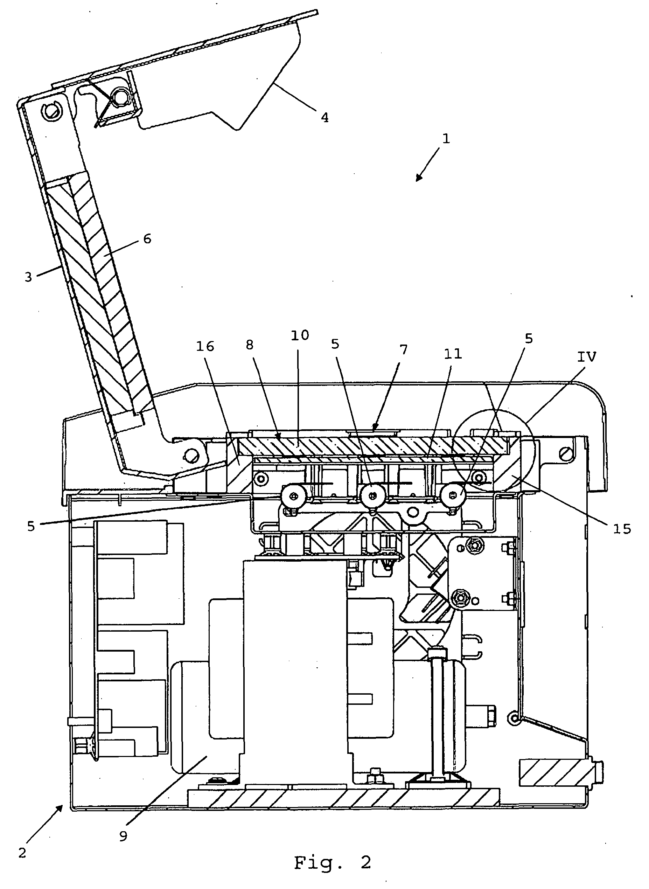

In Fig. 1 und 2 ist eine Flash-Vorrichtung 1 gezeigt, die, was die grundsätzliche Konstruktion sowie die elektrische Steuerung und Energieversorgung der Belichtungsmittel anlangt, von an sich herkömmlicher Bauart ist, so dass sich die diesbezügliche Beschreibung hier kurz halten kann.

Die Vorrichtung 1 weist ein Gehäuse 2 auf, an dessen Oberseite ein Klappdeckel 3 verschwenkbar befestigt ist. Dieser Klappdeckel 3 ist mit einem vorderseitigen gelenkigen Verriegelungsmechanismus 4 versehen, der in der Schließlage des Deckels 3 (die in Fig. 1 im Querschnitt gezeigt ist) in an sich herkömmlicher Weise mit entsprechenden Verriegelungselementen an der Vorderseite des Gehäuses 2 (nicht näher dargestellt) zusammenwirkt. Insbesondere kann dabei auch ein an sich herkömmlicher Sicherheitsmechanismus eingebaut sein, der ein Aktivieren der Belichtungsmittel, hier in Form von drei Belichtungs- bzw. Blitzlampen 5 (siehe Fig. 2; im Querschnitt gemäß Fig. 1 ist nur eine dieser Belichtungslampen 5 ersichtlich) ermöglicht.

Der Deckel 3 ist an seiner Innenseite mit einem bevorzugt austauschbar vorgesehenen Pressteil oder Andrückteil 6 versehen, der im geschlossenen Zustand des Deckels 3 (siehe Fig. 1) einen Stempelplatten-Rohling 7 (siehe Fig. 2) gegen eine Glasplatten-Auflage 8 drückt. Dabei wird zwischen dem Rohling 7 und der Auflage 8 eine in der Zeichnung nicht näher erkennbare Schablone oder Maske angeordnet, die beispielsweise mit Hilfe eines Computers erstellt wurde, und die die Form des Klischees festlegt, das an der Unterseite des Rohlings 7 (gemäß Darstellung in Fig. 1 und 2) beim "Flashen" durch lokales Verschließen von Poren des aus entsprechendem Schaumstoff-Material bestehenden Rohlings 7 erzeugt wird. Die Schablone maskiert somit Bereiche der Unterseite des Rohlings 7, und in diesen maskierten Bereichen wird wie an sich bekannt beim Flashen das Schaumstoff-Material unverändert mit den ausmündenden Poren belassen, so dass später bei Verwendung der Stempelplatte an diesen Stellen die Stempelfarbe durch das poröse Schaumstoff-Material der Stempelplatte hindurchtreten kann, um einen Abdruck auf der jeweiligen Unterlage zu erzeugen. In anderen Bereichen lässt die Schablone oder Maske die Unterseite des Stempelplatten-Rohlings 7 frei, so dass diese Bereiche beim Aktivieren der Belichtungslampen 5 "geflasht" werden, d.h. mit energiereichem Licht bestrahlt werden, wobei die Energie so hoch ist, dass das Schaumstoff-Material derart erhitzt wird, dass die Poren des Rohlings 7 an diesen Stellen durch Verschweißen geschlossen werden. Dadurch kann an diesen Stellen bei der fertigen Stempelplatte keine Farbe hindurchtreten, so dass an diesen Stellen an der Unterlage beim Stempeln kein Farbabdruck erzeugt wird.

Diese Technologie ist an sich bekannt und bedarf somit hier keiner weiteren Erläuterung. Es sei nur erwähnt, dass bei der vorliegenden Vorrichtung 1 zur Erzeugung der hohen Energien beim Flashen entsprechend stark dimensionierte Elektrolytkondensatoren 9 vorgesehen sind, die durch eine entsprechende nicht näher veranschaulichte, an sich übliche elektrische Schaltung aufgeladen und beim Flashen entladen werden.

Durch die energiereiche Strahlung beim Flashen wurde, wie sich gezeigt hat, in der Vergangenheit die - gemäß Stand der Technik einfache - Glasplatten-Auflage 8 relativ rasch erhitzt, so dass ein Flashen von größeren Anzahlen von Stempelplatten-Rohlingen 7 nicht möglich war, d.h. es musste nach Herstellen von einigen wenigen Stempelplatten zugewartet werden, bis die Glasplatten-Auflage 8 wieder abgekühlt war, bevor die nächsten Rohlinge 7 geflasht werden konnten.

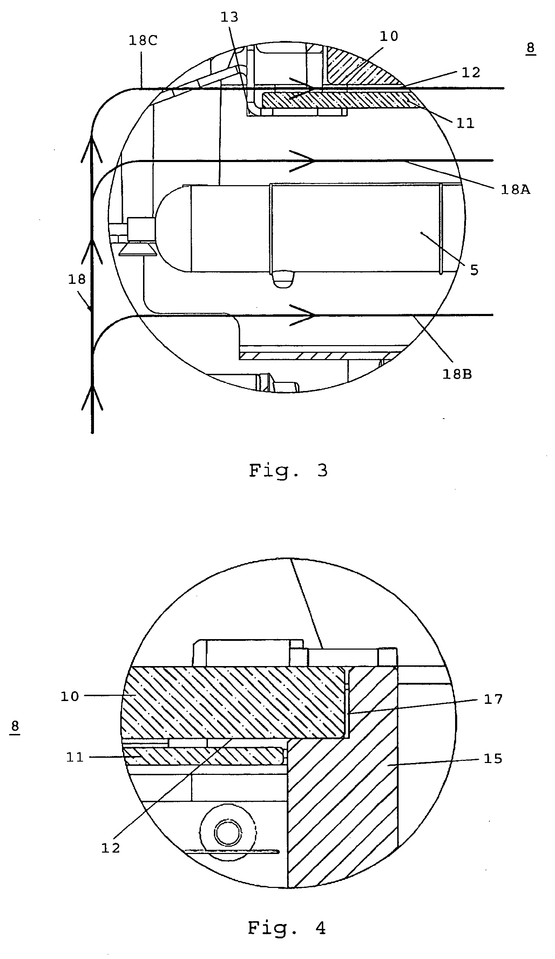

Um hier Abhilfe zu schaffen, ist bei der vorliegenden Vorrichtung 1 die Glasplatten-Auflage 8 mit zwei übereinander und parallel zueinander angeordneten Glasplatten 10, 11 ausgebildet, vgl. hierzu insbesondere auch die in größerem Maßstab wiedergegebenen Detailzeichnungen der Fig. 3 und 4. Zwischen den beiden Glasplatten 10 und 11 ist somit ein Zwischenraum 12 gebildet, der eine stark isolierende Wirkung hat. Dies führt dazu, dass sich zwar die untere Glasplatte 11 beim Flashen erwärmt, die obere Glasplatte 10 jedoch im Flashbetrieb nicht so stark erhitzt wird, so dass Stempelplatten-Rohlinge 7 mit hoher Frequenz, d.h. in großen Stückzahlen hintereinander, geflasht werden können, um die gewünschten Stempelplatten-Klischees zu erzeugen.

Wie im Detail aus Fig. 3 ersichtlich ist, ist die untere Glasplatte 11 an sich seitlich an der Oberseite des Gehäuses erstreckenden Winkelleisten 13 angebracht, wobei diese Winkelleisten an der Deckwand 14 des Gehäuses 2 befestigt sind (oder aber gegebenenfalls mit dieser einstückig, beispielsweise aus gebogenem Blech, ausgebildet sind).

Die obere Glasplatte 10 ist hingegen an vorderen und hinteren Halteleisten 15, 16 abgestützt, die ebenfalls an der Oberseite des Gehäuses 2 befestigt sind, und die mit stufenförmigen Absätzen 17 für die Auflage der Glasplatte 10 versehen sind; vgl. insbesondere Fig. 2 und 4.

Die obere Glasplatte 10 ist vergleichsweise dick, wobei ihre Dicke beispielsweise ca. 8 mm betragen kann. Dagegen ist die untere Glasplatte relativ dünn, beispielsweise mit einer Dicke von ca. 2 mm, und der Abstand zwischen den beiden Glasplatten 10 und 11, d.h. die Höhe des Zwischenraums 12, kann beispielsweise ca. 1 mm betragen. Es hat sich in Tests gezeigt, dass bei diesem Abstand von 1 mm, d.h. bei einer Höhe des Zwischenraums 12 von ca. 1 mm, bereits eine ausreichende Isolierwirkung im Hinblick auf das gewünschte Temperaturverhalten an der Oberseite der oberen Glasplatte 10 erzielt werden kann.

Dieses Temperaturverhalten wird zusätzlich dadurch verbessert, dass wie aus Fig. 1 und 3 ersichtlich Kühlluft 18 von außerhalb des Gehäuses 2 (siehe Fig. 1) durch den oberen Bereich des Gehäuses 2 transportiert wird. Dieser Kühlluftstrom wird mit Hilfe von zwei am Gehäuse 2 seitlich angebrachten, einander gegenüberliegenden Ventilatoren 19, 19' bewirkt, wobei der eine Ventilator 19 die Kühlluft 18 in das Innere des Gehäuses 2 drückt, d.h. als Druck-Gebläse wirkt, wogegen der andere Ventilator 19' auf der gegenüberliegenden Seite des Gehäuses 2 die Kühlluft aus dem Inneren des Gehäuses 2 ansaugt und in einem Luftstrom 18' nach außen führt, d.h. dieser Ventilator 19' wirkt als Saug-Gebläse.

Im Inneren des Gehäuses 2 wird der Kühlluftstrom 18 primär auf Teilströme, d.h. Kühlluftpfade 18A, 18B aufgezweigt, die zur Kühlung der Belichtungs- oder Blitzlampen 5 dienen. Ein weiterer Teil-Kühlluftstrom oder -Kühlluftpfad 18C verläuft durch den Zwischenraum 12 zwischen den beiden Glasplatten 10 und 11 und trägt dort zusätzlich zu einem Temperieren (Kühlhalten) der oberen Glasplatte 10 bei.

Für eine kompakte Konstruktion der Flash-Vorrichtung 1 insgesamt hat es sich als vorteilhaft gezeigt, wenn zwei Ventilatoren 19, 19' mit flacher Bauweise, auch wenn je mit vergleichsweise geringer Durchsatzleistung, verwendet werden, da sich die Ventilator-Leistungen dann summieren.

Jedem Ventilator 19 bzw. 19' ist an der Außenseite weiters ein Luftfilter 20 bzw. 20' zugeordnet, um die angesaugte Luft zu filtern. Dabei ist der Luftfilter 20' am Ventilator 19' insofern auch vorteilhaft, als gegebenenfalls die Umlaufrichtung und damit die Förderrichtung der Kühlluft umgekehrt werden kann, wobei dann der Ventilator 19' als Druck-Gebläse und der Ventilator 19 als Saug-Gebläse fungiert.

Weiters ist im Bereich der beiden Ventilatoren 19, 19' jeweils eine Abdeckung 21 bzw. 21' am Gehäuse 2 vorgesehen, die zwischen ihr und der eigentlichen Seitenwand des Gehäuses einen Luftkanal 22 bzw. 22' definiert. In der jeweiligen Seitenwand 2A bzw. 2B ist selbstverständlich an der Stelle des Ventilators 19 bzw. 19' ein entsprechender, z.B. kreisförmiger Ausschnitt vorzusehen, um den Luftdurchlass zu ermöglichen; dies ist in der Zeichnung jedoch nicht näher dargestellt, da an sich herkömmlich.

Wenn die Erfindung vorstehend anhand von bevorzugten Ausführungsbeispielen erläutert wurde, so sind doch weitere Abwandlungen und Modifikationen möglich, ohne den Rahmen der Erfindung zu verlassen, der durch die angehängten Ansprüche definiert ist. So ist es beispielsweise denkbar, als Glasplatten-Auflage 8 mehr als zwei beabstandete Glasplatten, z.B. drei Glasplatten, jeweils mit Zwischenraum, vorzusehen. Die "Glas"platten können aus jedem geeigneten transparenten Material, z.B. Acrylglas, aber auch Quarzglas etc. bestehen. Zur Führung der Kühlluft im Gehäuseinneren können auch Leitflächen (Leitbleche) vorgesehen werden.

## Patentansprüche

1. Vorrichtung (1) zum Herstellen von Stempel-Klischees durch örtliches Belichten und Erhitzen eines Stempelplatten-Rohlings (7) aus einem porösen, thermoplastischen Material, mit wenigstens einer Belichtungslampe (5), die in einem Gehäuse (2) unter einer Glasplatten-Auflage (8) für den Rohling (7) angeordnet ist, **dadurch gekennzeichnet, dass** die Glasplatten-Auflage (8) mit zwei in Abstand, unter Bildung eines Zwischenraums (12), übereinander angeordneten Glasplatten (10, 11) gebildet ist, dass das Gehäuse (2) an zwei einander gegenüberliegenden Seiten mit jeweils einem Ventilator (19, 19') versehen ist, von denen einer als Druck-Gebläse (19) und der andere als Saug-Gebläse (19') vorgesehen ist, wobei ein erster Kühlluftpfad (18A, 18B) im Bereich der Belichtungslampe (5) gegeben ist und der Zwischenraum (12) zwischen den Glasplatten (10, 11) einen weiteren Kühlluftpfad (18C) bildet und wobei der erste Kühlluftpfad (18A, 18B) und der weitere Kühlluftpfad (18C) zwischen den Ventilatoren (19, 19') parallel zueinander angeordnet sind.

2. Vorrichtung nach Anspruch 1, **dadurch gekennzeichnet, dass** an jedem Ventilator (19, 19') ein Luftfilter (20, 20') vorgesehen ist.

3. Vorrichtung nach Anspruch 1 oder 2, **dadurch gekennzeichnet, dass** jedem Ventilator (19, 19') eine seitlich am Gehäuse (2) angebrachte Abdeckung (21, 21'), die einen Luftkanal (22, 22') definiert, zugeordnet ist.

4. Vorrichtung nach einem der Ansprüche 1 bis 3, **dadurch gekennzeichnet, dass** die beiden Glasplatten (10, 11) verschieden dick sind, wobei die dünnere Glasplatte (11) benachbart der Belichtungslampe (5) als Schutz für diese und die dickere Glasplatte (10) als Auflage für den Rohling (7) vorgesehen ist.

5. Vorrichtung nach Anspruch 4, **dadurch gekennzeichnet, dass** die dickere Glasplatte (10) ca. 8 mm dick ist.

6. Vorrichtung nach Anspruch 4 oder 5, **dadurch gekennzeichnet, dass** die dünnere Glasplatte (11) ca. 2 mm dick ist.

7. Vorrichtung nach einem der Ansprüche 1 bis 6, **dadurch gekennzeichnet, dass** der Abstand zwischen den Glasplatten (10, 11) ca. 1 mm beträgt.

## Claims

1. An apparatus (1) for manufacturing stamp printing blocks by local exposure and heating of a stamp plate blank (7) made of a porous thermoplastic material, said apparatus comprising at least one exposure lamp (5) which is arranged in a housing (2) beneath a glass plate support (8) for the blank (7), **characterized in that** the glass plate support (8) is formed with two glass plates (10, 11) which are arranged one above the other in a spaced apart relationship, thereby forming a gap (12) between them, that the housing (2) is provided with a respective fan (19, 19') at two opposing sides, wherein one of the fans is provided as a pressure fan (19) and the other one is provided as a suction fan (19'), wherein a first cooling air path (18A, 18B) is provided in the area of the exposure lamp (5) and the gap (12) between the glass plates (10, 11) forms a further cooling air path (18C), and wherein the first cooling air path (18A, 18B) and the further cooling air path (18C) are arranged parallel to each other between the fans (19, 19').

2. The apparatus according to claim 1, **characterized in that** at each fan (19, 19') an air filter (20, 20') is provided.

3. The apparatus according to claim 1 or 2, **characterized in that** to each fan (19, 19') a cover (21, 21') is allocated which is mounted laterally at the housing (2), said cover defining an air channel (22, 22').

4. The apparatus according to any of claims 1 to 3, **characterized in that** the two glass plates (10, 11) have different thicknesses, wherein the thinner glass plate (11) is provided adjacent to the exposure lamp (5) as a protection therefor, and the thicker glass plate (10) is provided as a support for the blank (7).

5. The apparatus according to claim 4, **characterized in that** the thicker glass plate (10) has a thickness of approximately 8 mm.

6. The apparatus according to claim 4 or 5, **characterized in that** the thinner glass plate (11) has a thickness of approximately 2 mm.

7. The apparatus according to any of claims 1 to 6, **characterized in that** the distance between the glass plates (10, 11) is approximately 1 mm.

## Revendications

1. Dispositif (1) pour réaliser des clichés de tampon par illumination localisée et chauffage d'une ébauche de plaque de cliché (7) en un matériau thermoplastique poreux, comprenant au moins une lampe d'illumination (5) qui est agencée dans un boîtier (2) sous une plaque de support en verre (8) pour l'ébauche (7), **caractérisé en ce que** la plaque de support en verre (8) est formée avec deux plaques en verre (10, 11) agencées à distance l'une au-dessus de l'autre en formant un intervalle (12),
**en ce que** le boîtier (2) est doté sur deux côtés mutuellement opposés d'un ventilateur respectif (19, 19'), parmi lesquels un ventilateur est prévu à titre de ventilateur de soufflage (19) et l'autre à titre de ventilateur d'aspiration (19'), dans lequel un premier trajet d'air de refroidissement (18A, 18B) existe dans la région de la lampe d'illumination (5), et l'intervalle (12) entre les plaques en verre (10, 11) forme un autre trajet d'air de refroidissement (18C), et dans lequel le premier trajet d'air de refroidissement (18A, 18B) et l'autre trajet d'air de refroidissement (18C) sont agencés parallèlement l'un à l'autre entre les ventilateurs (19, 19').

2. Dispositif selon la revendication 1, **caractérisé en ce qu'**un filtre à air (20, 20') est prévu au niveau de chaque ventilateur (19, 19').

3. Dispositif selon la revendication 1 ou 2, **caractérisé en ce qu'**une couverture (21, 21'), agencée latéralement sur le boîtier (2) et définissant un canal d'air (22, 22'), est associée à chaque ventilateur (19, 19').

4. Dispositif selon l'une des revendications 1 à 3, **caractérisé en ce que** les deux plaques en verre (10, 11) ont des épaisseurs différentes, telles que la plaque en verre (11) plus mince est prévue au voisinage de la lampe d'illumination (3) à titre de protection pour celle-ci, et la plaque en verre plus épaisse est prévue à titre de support pour l'ébauche (7).

5. Dispositif selon la revendication 4, **caractérisé en ce que** la plaque en verre plus épaisse (10) a une épaisseur d'environ 8 mm.

6. Dispositif selon la revendication 4 ou 5, **caractérisé en ce que** la plaque en verre plus mince (11) a une épaisseur d'environ 2 mm.

7. Dispositif selon l'une des revendications 1 à 6, **caractérisé en ce que** la distance entre les plaques en verre (10, 11) est d'environ 1 mm.
